(19) Europäisches Patentamt
European Patent Office
Office européen des brevets

(11) EP 4 768 942 A1

(12) EUROPEAN PATENT APPLICATION
published in accordance with Art. 153(4) EPC

(43) Date of publication:
01.07.2026 Bulletin 2026/27

(51) International Patent Classification (IPC):
G01R 31/382 (2019.01)        G01R 31/392 (2019.01)
G01R 31/367 (2019.01)        G01R 19/165 (2006.01)
G01R 31/56 (2020.01)         H02J 7/00 (2026.01)

(21) Application number: 24937279.8

(22) Date of filing: 19.11.2024

(52) Cooperative Patent Classification (CPC):
G01R 19/165; G01R 31/367; G01R 31/382;
G01R 31/392; G01R 31/56; H02J 7/00

(86) International application number:
PCT/KR2024/018216

(87) International publication number:
WO 2025/225806 (30.10.2025 Gazette 2025/44)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 24.04.2024 KR 20240054761

(71) Applicant: LG Energy Solution, Ltd.
Seoul 07335 (KR)

(72) Inventor: SUNG, Yong Chul
Daejeon 34122 (KR)

(74) Representative: Plasseraud IP
104 Rue de Richelieu
CS92104
75080 Paris Cedex 02 (FR)

(54) **BATTERY DIAGNOSIS DEVICE AND METHOD**

(57) A battery diagnosis apparatus according to an embodiment disclosed herein includes an interface unit configured to obtain a state of charge (SOC) value of each of a plurality of battery cells and one or more processors configured to calculate a charging/discharging SOC difference in every charging/discharging cycle for each of the plurality of battery cells, calculate an SOC difference-to-average of each of the plurality of battery cells, based on the charging/discharging SOC difference, calculate a plurality of indicators one-to-one corresponding to the plurality of battery cells, based on the SOC difference-to-average, and diagnose abnormality of each of the plurality of battery cells based on the plurality of indicators.

100

INTERFACE UNIT
110

ONE OR MORE PROCESSORS
120

FIG.1

EP 4 768 942 A1

Description

## TECHNICAL FIELD

### CROSS-REFERENCE TO RELATED APPLICATION

This application claims priority to and the benefit of Korean Patent Application No. 10-2024-0054761 filed in the Korean Intellectual Property Office on April 24, 2024, the entire content of which is incorporated herein by reference.

### TECHNICAL FIELD

Embodiments disclosed herein relate to a battery diagnosis apparatus and method.

## BACKGROUND ART

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

Furthermore, the secondary battery is generally used as a battery pack including a battery module where a plurality of battery cells are connected to one another in series and/or in parallel. The secondary battery may be used as a battery rack including a plurality of battery modules and a rack frame receiving the battery modules.

The battery cell, the battery module, the battery pack, or the battery rack may be used in various devices. For example, the batteries may be used not only for mobile devices such as mobile phones, laptop computers, smart phones, smart pads, etc., but also in the field of vehicles (electric vehicles (EV), hybrid electric vehicles (HEV), plug-in HEV (PHEV)) driven with electricity, large-volume energy storage systems (ESS), etc.

These batteries may be managed and controlled in terms of states and operations thereof by a battery management system (BMS). The battery management system may be included together with a battery in one device.

The battery management system may also manage and control the battery in a state of being spaced apart from a device including the battery. For example, the battery management system may be implemented as a separate server device. In this case, the battery management system may collect battery data and vehicle data from the vehicle, etc., and manage and control the battery using the collected data.

Meanwhile, when a battery has a defect, the possibility of damage to devices (e.g., an EV, an ESS) including the battery may increase. Accordingly, there is a need for a scheme to reduce the possibility of damage to devices including a battery by detecting an abnormal state of the battery.

## DISCLOSURE

### TECHNICAL PROBLEM

Generally, an abnormal behavior diagnosis of a voltage due to a tab short-circuit, etc., of a battery cell may be one of major items of abnormal diagnosis of the battery cell. However, a conventional voltage abnormal behavior diagnosis method has a limitation in detecting a subtle voltage change.

Embodiments disclosed herein aim to provide a battery diagnosis apparatus and method capable of effectively diagnosing abnormality of a battery cell by defining an SOC difference-to-average of each battery cell based on SOC of battery cells and analyzing the SOC difference-to-average to detect a subtle voltage change.

Technical problems of the embodiments disclosed herein are not limited to the above-described technical problems, and other unmentioned technical problems would be clearly understood by one of ordinary skill in the art from the following description.

### TECHNICAL SOLUTION

A battery diagnosis apparatus according to an embodiment disclosed herein includes an interface unit configured to obtain a state of charge (SOC) value of each of a plurality of battery cells and one or more processors configured to calculate a charging/discharging SOC difference in every charging/discharging cycle for each of the plurality of battery cells, calculate an SOC difference-to-average of each of the plurality of battery cells, based on the charging/discharging SOC difference, calculate a plurality of indicators one-to-one corresponding to the plurality of battery cells, based on the SOC difference-to-average, and diagnose abnormality of each of the plurality of battery cells based on the plurality of indicators.

According to an embodiment, the processor may be further configured to, for each of the plurality of battery cells, obtain first SOC before start of charging after discharging and second SOC after charging in every charging/discharging cycle and obtain a difference between the first SOC and the second SOC as the charging/discharging SOC difference.

According to an embodiment, the processor may be further configured to calculate an average charging/discharging SOC difference of the plurality of battery cells in every charging/discharging cycle, calculate a total cycle average based on average charging/discharging SOC differences calculated in every charging/discharging cycle, and calculate the SOC difference-to-average based on the charging/discharging SOC difference, the average charging/discharging SOC difference, and the total cycle average.

According to an embodiment, the processor may be further configured to calculate a first target value indicating an average of SOC differences-to-average of a diagnosis target battery cell among the plurality of battery cells in all cycles, calculate a second target value indicating an average of all SOC differences-to-average of the plurality of battery cells in all cycles, and calculate an indicator of the diagnosis target battery cell based on the first target value and the second target value.

According to an embodiment, the processor may be further configured to diagnose the diagnosis target battery cell as an abnormal battery cell when the indicator of the diagnosis target battery cell is greater than or equal to a threshold value.

A battery diagnosis method according to an embodiment disclosed herein includes obtaining a state of charge (SOC) value of each of a plurality of battery cells, calculating a charging/discharging SOC difference in every charging/discharging cycle for each of the plurality of battery cells, calculating an SOC difference-to-average of each of the plurality of battery cells, based on the charging/discharging SOC difference, calculating a plurality of indicators one-to-one corresponding to the plurality of battery cells, based on the SOC difference-to-average, and diagnosing abnormality of each of the plurality of battery cells based on the plurality of indicators.

According to an embodiment, the calculating of the charging/discharging SOC difference may include, for each of the plurality of battery cells, obtaining first SOC before start of charging after discharging and second SOC after charging in every charging/discharging cycle, and obtaining a difference between the first SOC and the second SOC as the charging/discharging SOC difference.

According to an embodiment, the calculating of the SOC difference-to-average may include calculating an average charging/discharging SOC difference of the plurality of battery cells in every charging/discharging cycle, calculating a total cycle average based on average charging/discharging SOC differences calculated in every charging/discharging cycle, and calculating the SOC difference-to-average based on the charging/discharging SOC difference, the average charging/discharging SOC difference, and the total cycle average.

According to an embodiment, the calculating of the plurality of indicators may include calculating a first target value indicating an average of SOC differences-to-average of a diagnosis target battery cell among the plurality of battery cells in all cycles, calculating a second target value indicating an average of all SOC differences-to-average of the plurality of battery cells in all cycles, and calculating an indicator of the diagnosis target battery cell based on the first target value and the second target value.

According to an embodiment, the diagnosing of abnormality of each of the plurality of battery cells may include diagnosing the diagnosis target battery cell as an abnormal battery cell when the indicator of the diagnosis target battery cell is greater than or equal to a threshold value.

## ADVANTAGEOUS EFFECTS

A battery diagnosis apparatus and method according to embodiments disclosed herein may effectively diagnose abnormality of a battery cell by defining an SOC difference-to-average of a battery cell based on SOC.

In addition, various effects identified directly or indirectly through this document may be provided.

## DESCRIPTION OF DRAWINGS

FIG. 1 shows a configuration of a battery diagnosis apparatus according to an embodiment disclosed herein.
FIG. 2 shows an example of obtaining a charging/discharging SOC difference, according to an embodiment disclosed herein.
FIGS. 3A to 3C show an example of a process of diagnosing a battery, according to an embodiment disclosed herein.

FIG. 4 is a diagram showing an example of a process of calculating an indicator from charging/discharging SOC difference data, according to an embodiment disclosed herein.

FIGS. 5 to 7 are flowcharts of a battery diagnosis method according to an embodiment disclosed herein.

FIG. 8 is a block diagram showing a hardware configuration of a computing system for performing an operating method of a battery diagnosis apparatus, according to an embodiment disclosed herein.

## MODE FOR INVENTION

Hereinafter, various embodiments of the present disclosure will be described with reference to the accompanying drawings. However, the description is not intended to limit the present disclosure to particular embodiments, and it should be construed as including various modifications, equivalents, and/or alternatives according to the embodiments of the present disclosure.

Herein, it is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

Each component (e.g., a module or a program) of the components described herein may include a single entity or multiple entities. According to various embodiments, one or more of the components may be omitted, or one or more other components may be added. Alternatively or additionally, a plurality of components (e.g., modules or programs) may be integrated into one component. In this case, the integrated component may perform one or more functions of each of the plurality of components in a manner that is the same as or similar to a corresponding component of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

As used herein, the term "module" or "...unit" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments of the present document may be implemented as software (e.g., a program or application) including one or more instructions that are stored in a storage medium (e.g., a memory) that is readable by a machine. For example, a processor of the machine may invoke at least one of the one or more instructions stored in the storage medium, and execute it. This may enable the machine to operate to perform at least one function according to the at least one called instruction. The one or more instructions may include a code generated by a compiler or a code executable by an interpreter. A machine-readable storage medium may be provided in the form of a non-transitory storage medium. Herein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

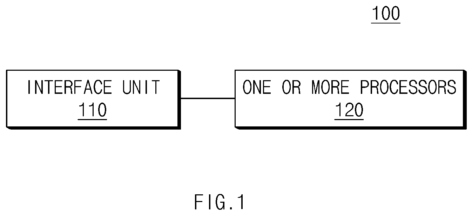

FIG. 1 shows a configuration of a battery diagnosis apparatus according to an embodiment disclosed herein.

Referring to FIG. 1, the battery diagnosis apparatus 100 may include an interface unit 110 and one or more processor 120.

The battery diagnosis apparatus 100 may analyze SOC of a plurality of battery cells to diagnose whether a diagnosis target battery is abnormal. More specifically, the battery diagnosis apparatus 100 may define an SOC difference-to-average based on SOC of a battery cell and detect a subtle voltage change of the battery cell by analyzing the SOC difference-to-average, thereby effectively diagnosing abnormality such as a tab short-circuit, etc., causing the subtle voltage change.

The following operation of the battery diagnosis apparatus 100 may also be performed in various devices such as not only a battery management system (BMS) in a vehicle and a battery BMS included in a battery pack, but also a server, a cloud, a charger, a charger/discharger, etc.

The interface unit 110 may establish connection between the battery diagnosis apparatus 100 and an electronic device (e.g., a server, a BMS of a battery pack, a vehicle BMS, etc.) and transmit and receive data through the established connection. The connection between the interface unit 110 and the electronic device may be communication connection over a wired and/or wireless network. In an embodiment, the wired network may be based on a local area network (LAN) communication or a power-line communication. In an embodiment, the wireless network may be based on a short-range communication network (e.g., Bluetooth, Wireless Fidelity (WiFi), or Infrared Data Association (IrDA)) or a remote-range communication network (e.g., a cellular network, a 4th-Generation (4G) network, a 5th-Generation (5G) network).

According to another embodiment, the connection between the battery diagnosis apparatus 100 and the electronic device may be connection using a device-to-device communication scheme (e.g., a bus, a general-purpose input and output (GPIO), a serial peripheral interface (SPI), or a mobile industry processor interface (MIPI)).

The interface unit 110 may obtain information of the plurality of battery cells. The plurality of battery cells may be cells included in the same battery pack, module, or bank.

In an embodiment, when the battery diagnosis apparatus 100 is implemented with a component (e.g., an external server for the electronic device, etc.) separate from the electronic device, the interface unit 110 may obtain information of battery cells through a communication channel established between the battery diagnosis apparatus 100 and the electronic device.

In another embodiment, when the battery diagnosis apparatus 100 is implemented with a BMS in the electronic device, the interface unit 110 may obtain the information of the battery cells from at least one sensor capable of measuring information (e.g., voltage, current, temperature, etc.) related to states of the battery cells.

The interface unit 110 may obtain an SOC value of each of the plurality of battery cells. The interface unit 110 may obtain an SOC value of each of the plurality of battery cells in every charging/discharging cycle. The interface unit 110 may obtain time-series data regarding SOC of each battery cell in every charging/discharging cycle.

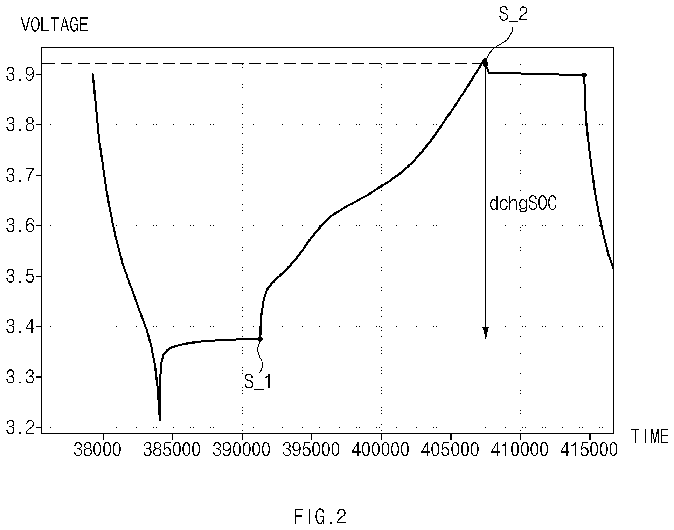

For example, the interface unit 110 may obtain battery data of the battery cell with respect to the charging/-discharging cycle, as shown in FIG. 2. In FIG. 2, an x axis may indicate a time and a y axis may indicate a voltage, and SOC of a battery cell may be obtained in each point of the graph shown in FIG. 2. That is, the battery diagnosis apparatus 100 may identify a time point for obtaining SOC of a battery cell from voltage data over time.

In an embodiment, first SOC may be obtained at a point in time when a voltage is stabilized before start of charging in a current charging/discharging cycle after end of discharging in a previous charging/discharging cycle, and second SOC may be obtained at a point in time immediately after charging in the current charging/discharging cycle.

Immediately after the end of discharging, there is a possibility of a voltage change of a battery cell, such that SOC of the battery cell may be obtained in a voltage-stabilized state after the end of discharging to obtain an accurate SOC value for use in calculation of a charging/discharging SOC difference. To this end, the interface unit 110 may obtain SOC of each battery cell at a point in time after the designated time from the end of discharging. For example, the designated time may be set to a time sufficient to stabilize a voltage, for example, one hour.

For example, the interface unit 110 may obtain SOC of a battery cell at a point in time $S\_1$ after the designated time from the end of discharging in FIG. 2. At a point in time $S\_2$ immediately after the end of charging, the SOC of the battery cell may be obtained. The processor 120 described below may calculate a difference dchgSOC between SOC obtained at the point $S\_1$ and the point $S\_2$ as a charging/discharging SOC difference.

The interface unit 110 may obtain additional information related to a battery, such as voltage, temperature, SOH, etc., of a battery cell as well as the SOC.

The processor 120 may be implemented as one or more processors. Each processor may include a central processing unit, an application processor, a graphic processing unit, a neural processing unit (NPU), an image signal processor, a sensor hub processor, or a communication processor.

The processor 120 may diagnose abnormality of a diagnosis target battery cell and/or each battery cell by using SOC values of the battery cells, obtained by the interface unit 110. For example, the processor 120 may calculate and analyze the charging/discharging SOC difference from an SOC value of each battery cell to detect a subtle voltage change in each battery cell, thereby diagnosing abnormality of the battery cell.

Functions and operations of the battery diagnosis apparatus 100 described below may be performed by one processor, and at least some of the functions may be separately performed by a plurality of processors. Hereinbelow, for convenience, a description will be made of a case where the operations of the battery diagnosis apparatus 100 are performed by one processor.

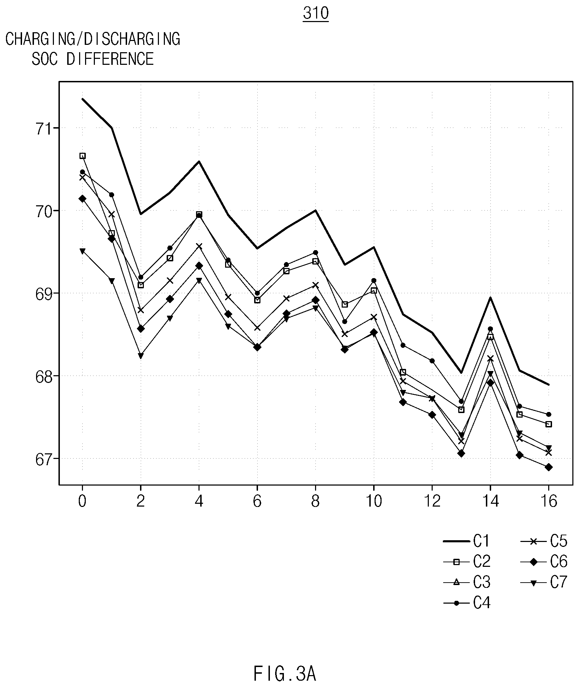

FIGS. 3A to 3C show an example of a process of diagnosing a battery, according to an embodiment disclosed herein.

Hereinbelow, with reference to FIGS. 3A to 3C, the operations of the battery diagnosis apparatus 100 will be described in detail.

First, the processor 120 may calculate a charging/discharging SOC difference in every charging/discharging cycle for each battery cell, as shown in a graph 310 of FIG. 3A. Herein, the charging/discharging SOC difference may be a parameter indicating a charging amount in a charging/discharging cycle.

According to an embodiment, the processor 120 may obtain the first SOC before start of charging after discharging and the second SOC after charging in every charging/discharging cycle and calculate a difference between the first SOC and the second SOC as a charging/discharging SOC difference, for each of the plurality of battery cells. The first SOC and the second SOC may be obtained from the interface unit 110. For example, the processor 120 may calculate a charging/discharging SOC difference by subtracting the first SOC from the second SOC, for each battery cell.

For example, the processor 120 may calculate a charging/discharging SOC difference of each battery cell from SOC data obtained from the interface unit 110 as shown in FIG. 2. For example, the processor 120 may calculate a difference between SOC (the second SOC) obtained at the point S_2 and SOC (the first SOC) obtained at the point S_1 in FIG. 2, as a charging/discharging SOC difference.

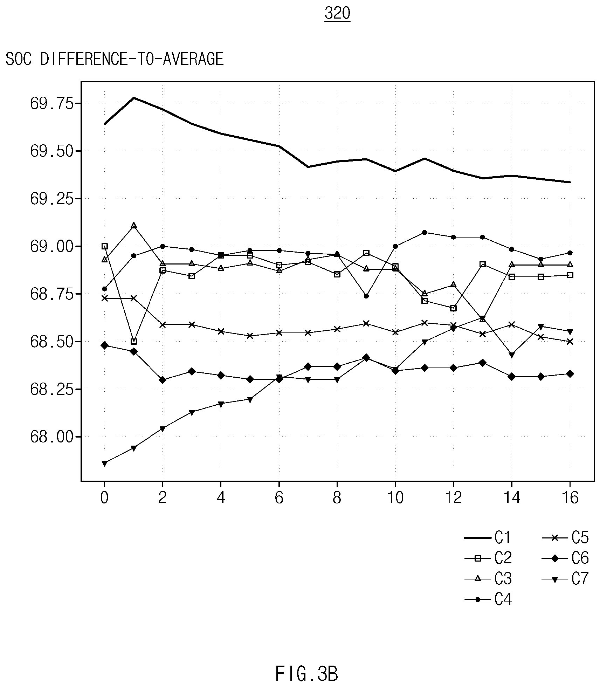

The graph 310 shows charging/discharging SOC difference data obtained after 17 charging cycles 0 to 16 of each of 7 battery cells C1 to C7 in which an x axis indicates a cycle number and a y axis indicates a charging/discharging SOC difference. Graphs shown in FIGS. 3B to 3E show values calculated based a charging/discharging SOC difference indicated in the graph 310 of FIG. 3A.

The processor 120 may calculate an SOC difference-to-average of each of the plurality of battery cells based on the charging/discharging SOC difference. Herein, the charging/discharging SOC difference-to-average may be a parameter defined for comparing relative charging amounts of the battery cells in each charging/discharging cycle. The processor 120 may calculate an SOC difference-to-average indicating a relative charging amount for each battery cell to detect a relative minute behavior of a diagnosis target battery cell in comparison to the other battery cells.

According to an embodiment, the processor 120 may calculate the charging/discharging SOC differences-to-average of the plurality of battery cells in every charging/discharging cycle. For each charging/discharging cycle, the processor 120 may average charging/discharging SOC differences of the battery cells, obtained in the corresponding charging/discharging cycle, to calculate an average charging/discharging SOC difference. For example, when 10 charging/discharging cycles progress for each battery cell, the processor 120 may calculate the average charging/-discharging SOC difference in every charging/discharging cycle to calculate 10 pieces of average charging/discharging SOC difference data.

The processor 120 may calculate a total cycle average based on the average charging/discharging SOC differences calculated in every charging/discharging cycle. The processor 120 may average the average charging/-discharging SOC differences to calculate the total cycle average.

The processor 120 may calculate an SOC difference-to-average based on the charging/discharging SOC difference, the average charging/discharging SOC difference, and the total cycle average. The processor 120 may convert the charging/discharging SOC difference of each battery cell into the SOC difference-to-average by using the average charging/discharging SOC difference and the total cycle average.

In an embodiment, the processor 120 may calculate the SOC difference-to-average of each battery cell based on Equation 1 below.

[Equation 1]

$$dchgSOCnorm = dchgSOC * (norm/avg)$$

Herein, dchgSOCnorm may indicate the SOC difference-to-average of each battery cell in each charging cycle, dchgSOC may indicate the charging/discharging SOC difference of each battery cell in each charging cycle, avg may indicate the SOC difference-to-average, and norm may indicate the total cycle average.

As such, the processor 120 may derive a relative charging amount of each battery cell. The SOC difference-to-average of each battery cell, calculated by the processor 120, may be shown in a graph 320 of FIG. 3B. As shown in the graph 320, it may be seen that the SOC difference-to-average of each battery cell has a clearer relative difference than the charging/discharging SOC difference shown in the graph 310.

The processor 120 may calculate a plurality of indicators one-to-one corresponding to the plurality of battery cells, based on the SOC difference-to-average. The indicator may be a value that is a reference for the processor 120 to diagnose abnormality of a battery cell. The processor 120 may calculate the indicator from the SOC difference-to-average to detect a subtle voltage change based on a change of the charging amount of the battery cell.

According to an embodiment, the processor 120 may calculate a first target value indicating an average of SOC differences-to-average of the diagnosis target battery cell among the plurality of battery cells in all the cycles. The processor 120 may calculate a second target value indicating an average of all the SOC differences-to-average of the plurality of battery cells in all the cycles.

Thereafter, the processor 120 may calculate an indicator of the diagnosis target battery cell based on the first target value and the second target value. As the first target value is a value reflecting an average SOC difference of the diagnosis target battery cell and the second target value reflects an average SOC difference of all the battery cells, the processor 120 may determine a degree of a relative change of the diagnosis target battery cell through comparison between and analysis of the first target value and the second target value.

In an embodiment, the processor 120 may calculate the indicator of the diagnosis target battery cell by subtracting the second target value from the first target value.

The processor 120 may diagnose abnormality of each of the plurality of battery cells based on the plurality of indicators. The indicators calculated as described above may reflect relative characteristics between the battery cells, such that the processor 120 may detect a subtle voltage change of the diagnosis target battery cell by using the indicators to diagnose abnormality.

In an embodiment, the processor 120 may diagnose, as an abnormal battery cell, a battery cell having an indicator greater than or equal to a threshold value. When the indicator of the diagnosis target battery cell is greater than the threshold value, it may mean that a relative difference of the cell from the other cells is greater, such that the processor 120 may compare the indicator with the threshold value to diagnose abnormality of the battery cell.

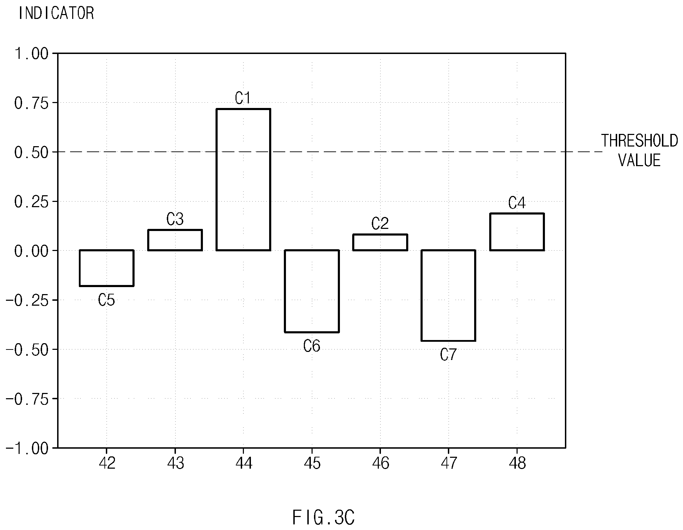

For example, the processor 120 may compare indicators calculated for each battery cell with the threshold value to diagnose abnormality of the battery cell, as shown in FIG. 3C. For example, in a graph 330, as the indicator of the cell C1 exceeds the threshold value, the processor 120 may diagnose that the cell C1 is abnormal.

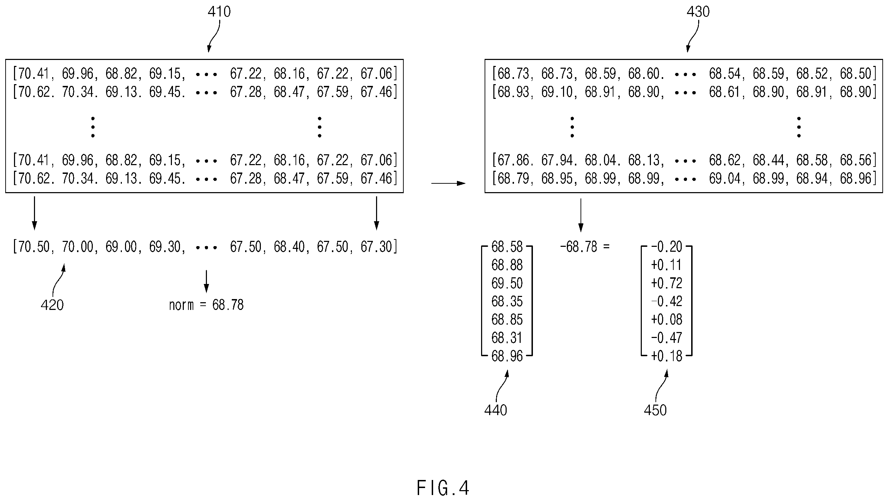

FIG. 4 is a diagram showing an example of a process of calculating an indicator from charging/discharging SOC difference data, according to an embodiment disclosed herein.

Referring to FIG. 4, an example of a process, performed by the processor 120, of analyzing data to diagnose each battery cell using data obtained from the interface unit 110 may be seen.

First, the interface unit 110 may obtain time-series data of an SOC value of each battery cell in every charging/discharging cycle, and the processor 120 may calculate a charging/discharging SOC difference of each battery cell in every charging/discharging cycle from the obtained SOC value. The calculated charging/discharging SOC difference may be expressed as a matrix 410 in which each row may indicate a battery cell, each column may indicate a charging/discharging cycle, and each component may indicate a charging/discharging SOC difference.

The processor 120 may average charging/discharging SOC differences of all the battery cells in every charging/discharging cycle to calculate an average charging/discharging SOC difference, and the average charging/-discharging SOC difference calculated from the matrix 410 may be shown as a matrix 420. That is, the processor 120 may calculate the matrix 420 through a process of averaging components of each column of the matrix 410.

The processor 120 may average again average charging/discharging SOC differences of each charging/discharging cycle to calculate the total cycle average in which the total cycle average calculated from the matrix 420 is expressed as a norm. That is, the processor 120 may average all components of the matrix 420 to calculate the total cycle average.

The processor 120 may calculate the SOC difference-to-average of each battery cell based on the charging/-discharging SOC difference, the average charging/discharging SOC difference, and the total cycle average, and an example of the SOC difference-to-average is shown as a matrix 430. Sizes of the matrix 410 and the matrix 430 may be the same as each other.

For each battery cell, the processor 120 may calculate the first target value indicating an average of SOC differences-to-average of the corresponding battery cell in all the cycles. The first target value of each battery cell, calculated from the matrix 430, may be shown as a matrix 440. That is, the processor 120 may average components of each row of the matrix 430 to calculate the matrix 440.

The processor 120 may calculate the second target value indicating an average of all the SOC differences-to-average of the plurality of battery cells in all the cycles. That is, the processor 120 may average all components of the matrix 430 to calculate the second target value.

The processor 120 may calculate an indicator of each battery cell based on the first target value and the second target value. In an embodiment, the processor 120 may calculate the indicator by subtracting the second target value from the first target value, and an example of the indicator is shown as a matrix 450. The processor 120 may compare indicators of each row of the matrix 450 with the threshold value to perform diagnosis of the battery cell.

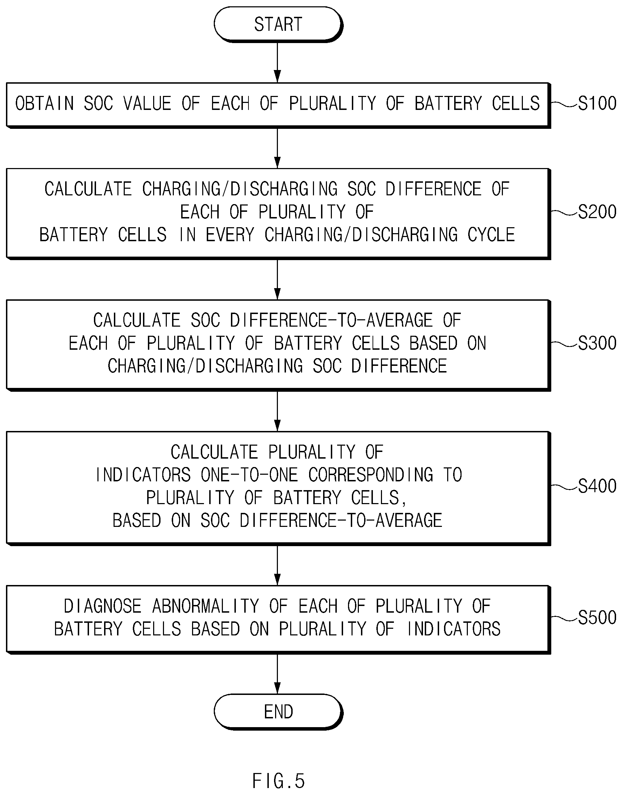

FIGS. 5 to 7 are flowcharts of a battery diagnosis method according to an embodiment disclosed herein.

Referring to FIG. 5, the battery diagnosis method may include operation S100 of obtaining an SOC value of each of a plurality of battery cells, operation S200 of calculating a charging/discharging SOC difference in every charging/-discharging cycle for each of the plurality of battery cells, operation S300 of an SOC difference-to-average of each of the plurality of battery cells based on the charging/discharging SOC difference, operation S400 of calculating a plurality of indicators one-to-one corresponding to the plurality of battery cells based on the SOC difference-to-average, and operation S500 of diagnosing abnormality of each of the plurality of battery cells based on the plurality of indicators.

In operation S100, the interface unit 110 may obtain an SOC value of each of the plurality of battery cells. The interface unit 110 may obtain time-series data regarding SOC for each of the plurality of battery cells.

In operation S200, the one or more processors 120 may calculate a charging/discharging SOC difference in every charging/discharging cycle for each of the plurality of battery cells. In an embodiment, the processor 120 may obtain the first SOC before start of charging after discharging and the second SOC after charging in every charging/discharging cycle and obtain a difference between the first SOC and the second SOC as a charging/discharging SOC difference, for each of the plurality of battery cells.

In operation S300, the one or more processors 120 may calculate the SOC difference-to-average of each of the plurality of battery cells based on the charging/discharging SOC difference.

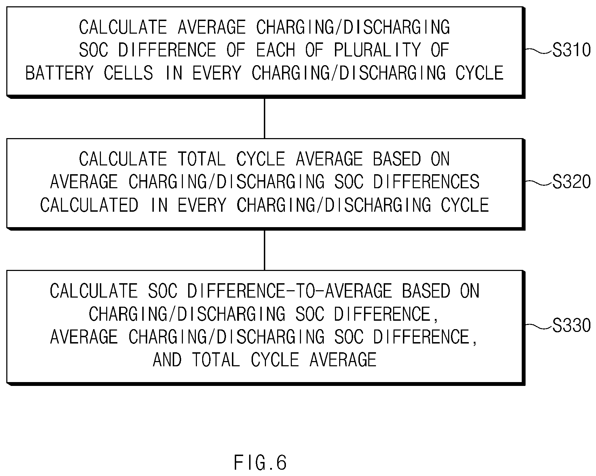

Referring to FIG. 6, a method, performed by the one or more processors 120 according to an embodiment, of calculating the SOC difference-to-average may include operation S310 of calculating the average charging/discharging SOC difference of the plurality of battery cells in every charging/discharging cycle, operation S320 of calculating the total cycle average based on the average charging/discharging SOC differences calculated in every charging/discharging cycle, and operation S330 of calculating the SOC difference-to-average based on the charging/discharging SOC difference, the average charging/discharging SOC difference, and the total cycle average.

In operation S310, the one or more processors 120 may calculate the average charging/discharging SOC difference of the plurality of battery cells in every charging/discharging cycle.

In operation S320, the one or more processors 120 may calculate the total cycle average based on the average charging/discharging SOC differences calculated in every charging/discharging cycle.

In operation S330, the one or more processors 120 may calculate the SOC difference-to-average based on the charging/discharging SOC difference, the average charging/discharging SOC difference, and the total cycle average.

In operation S400, the one or more processors 120 may calculate the plurality of indicators one-to-one corresponding to the plurality of battery cells, based on the SOC difference-to-average.

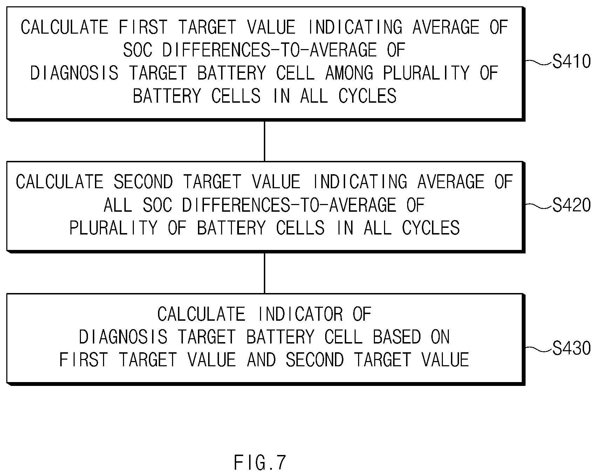

Referring to FIG. 7, a method, performed by the one or more processors 120 according to an embodiment, of calculating the plurality of indicators may include operation S410 of calculating the first target value indicating an average of SOC differences-to-average of the diagnosis target battery cell among the plurality of battery cells in all the cycles, operation S420 of calculating the second target value indicating an average of all the SOC differences-to-average of the plurality of battery cells in all the cycles, and operation S430 of calculating the indicator of the diagnosis target battery cell based on the first target value and the second target value.

In operation S410, the one or more processors 120 may calculate the first target value indicating the average of SOC differences-to-average of the diagnosis target battery cell among the plurality of battery cells in all the cycles.

In operation S420, the one or more processors 120 may calculate the second target value indicating the average of all the SOC differences-to-average of the plurality of battery cells in all the cycles.

In operation S430, the one or more processors 120 may calculate an indicator of the diagnosis target battery cell based on the first target value and the second target value.

In operation S500, the one or more processors 120 may diagnose abnormality of each of the plurality of battery cells based on the plurality of indicators.

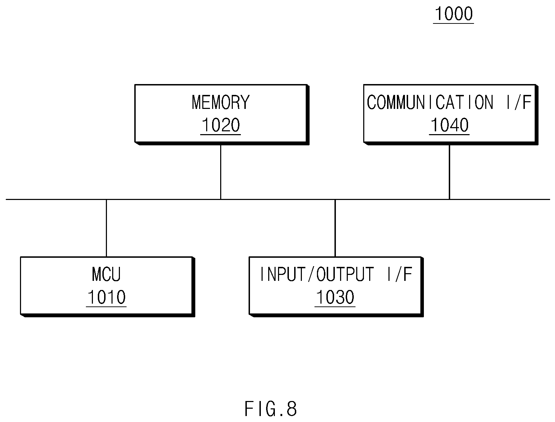

FIG. 8 is a block diagram showing a hardware configuration of a computing system for performing an operating method of a battery diagnosis apparatus, according to an embodiment disclosed herein.

Referring to FIG. 8, a computing system 1000 according to an embodiment disclosed herein may include a microcontroller unit (MCU) 1010, a memory 1020, an input/output interface (I/F) 1030, and a communication I/F 1040.

The memory 1010 may be a processor that executes various programs stored in the memory 1020, processes various information including time-series data of the battery through such programs, and causes functions of a processor included in the battery diagnosis apparatus shown in FIG. 1 to be performed.

The memory 1020 may store various programs for performing functions of the battery diagnosis apparatus. The memory 1020 may also store various information including battery data (SOC, etc.), a diagnosis prediction result, etc.

The memory 1020 may be provided in plural, depending on a need. The memory 1020 may be a volatile or nonvolatile memory. For the memory 1020 as the volatile memory, random access memory (RAM), dynamic RAM (DRAM), static RAM (SRAM), etc., may be used. For the memory 1020 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 1020 are merely examples and are not limited thereto.

The input/output I/F 1030 may provide an interface for transmitting and receiving data by connecting an input device (not shown) such as a keyboard, a mouse, a touch panel, etc., and an output device such as a display (not shown), etc., with the MCU 1010.

The communication I/F 1040, which is a component capable of transmitting and receiving various data to and from a server, may be various types of devices capable of supporting wired or wireless communication. For example, the battery diagnosis apparatus may transmit and receive various information including battery data, etc., from an external server separately provided through the communication I/F 1040.

As such, a computer program according to an embodiment disclosed herein may be recorded in the memory 1020 and processed by the MCU 1010, thus being implemented as a module that performs functions shown in FIG. 1.

Even though all components constituting an embodiment disclosed herein have been described above as being combined into one or operating in combination, the embodiments disclosed herein are not necessarily limited to the embodiment. That is, within the object scope of the embodiments disclosed herein, all the components may operate by being selectively combined into one or more.

Moreover, terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in this document.

The above description is merely illustrative of the technical idea disclosed herein, and various modifications and variations will be possible without departing from the essential characteristics of the embodiments disclosed herein by those of ordinary skill in the art to which the embodiments disclosed herein pertains. Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of this document.

## Claims

1. A battery diagnosis apparatus comprising:

    an interface unit configured to obtain a state of charge (SOC) value of each of a plurality of battery cells; and
    one or more processors configured to:

        calculate a charging/discharging SOC difference in every charging/discharging cycle for each of the plurality of battery cells;
        calculate an SOC difference-to-average of each of the plurality of battery cells, based on the charging/discharging SOC difference;
        calculate a plurality of indicators one-to-one corresponding to the plurality of battery cells, based on the SOC difference-to-average; and
        diagnose abnormality of each of the plurality of battery cells based on the plurality of indicators.

2. The battery diagnosis apparatus of claim 1, wherein the processor is further configured to, for each of the plurality of battery cells, obtain first SOC before start of charging after discharging and second SOC after charging in every charging/discharging cycle and obtain a difference between the first SOC and the second SOC as the charging/discharging SOC difference.

3. The battery diagnosis apparatus of claim 1, wherein the processor is further configured to:

    calculate an average charging/discharging SOC difference of the plurality of battery cells in every charging/discharging cycle;
    calculate a total cycle average based on average charging/discharging SOC differences calculated in every charging/discharging cycle; and
    calculate the SOC difference-to-average based on the charging/discharging SOC difference, the average charging/discharging SOC difference, and the total cycle average.

4. The battery diagnosis apparatus of claim 1, wherein the processor is further configured to:

    calculate a first target value indicating an average of SOC differences-to-average of a diagnosis target battery cell among the plurality of battery cells in all cycles;
    calculate a second target value indicating an average of all SOC differences-to-average of the plurality of battery cells in all cycles; and
    calculate an indicator of the diagnosis target battery cell based on the first target value and the second target value.

5. The battery diagnosis apparatus of claim 4, wherein the processor is further configured to diagnose the diagnosis target battery cell as an abnormal battery cell when the indicator of the diagnosis target battery cell is greater than or equal to a threshold value.

6. A battery diagnosis method comprising:

obtaining a state of charge (SOC) value of each of a plurality of battery cells;

calculating a charging/discharging SOC difference in every charging/discharging cycle for each of the plurality of battery cells;

calculating an SOC difference-to-average of each of the plurality of battery cells, based on the charging/discharging SOC difference;

calculating a plurality of indicators one-to-one corresponding to the plurality of battery cells, based on the SOC difference-to-average; and

diagnosing abnormality of each of the plurality of battery cells based on the plurality of indicators.

7. The battery diagnosis method of claim 6, wherein the calculating of the charging/discharging SOC difference comprises:

for each of the plurality of battery cells, obtaining first SOC before start of charging after discharging and second SOC after charging in every charging/discharging cycle; and

obtaining a difference between the first SOC and the second SOC as the charging/discharging SOC difference.

8. The battery diagnosis method of claim 6, wherein the calculating of the SOC difference-to-average comprises:

calculating an average charging/discharging SOC difference of the plurality of battery cells in every charging/-discharging cycle;

calculating a total cycle average based on average charging/discharging SOC differences calculated in every charging/discharging cycle; and

calculating the SOC difference-to-average based on the charging/discharging SOC difference, the average charging/discharging SOC difference, and the total cycle average.

9. The battery diagnosis method of claim 6, wherein the calculating of the plurality of indicators comprises:

calculating a first target value indicating an average of SOC differences-to-average of a diagnosis target battery cell among the plurality of battery cells in all cycles;

calculating a second target value indicating an average of all SOC differences-to-average of the plurality of battery cells in all cycles; and

calculating an indicator of the diagnosis target battery cell based on the first target value and the second target value.

10. The battery diagnosis method of claim 6, wherein the diagnosing of abnormality of each of the plurality of battery cells comprises diagnosing the diagnosis target battery cell as an abnormal battery cell when the indicator of the diagnosis target battery cell is greater than or equal to a threshold value.

100

| INTERFACE UNIT 110 | ONE OR MORE PROCESSORS 120 |

FIG.1

FIG.2

310

CHARGING/DISCHARGING
SOC DIFFERENCE

FIG.3A

320

SOC DIFFERENCE-TO-AVERAGE

FIG.3B

INDICATOR

FIG.3C

430

[68.73, 68.73, 68.59, 68.60. ... 68.54, 68.59, 68.52, 68.91, 68.50]
[68.93, 69.10, 68.91, 68.90, ... 68.61, 68.90, 68.91, 68.90]
...
[67.86, 67.94. 68.04. 68.13, ... 68.62, 68.44, 68.58, 68.56]
[68.79, 68.95, 68.99, 68.99, ... 69.04, 68.99, 68.94, 68.96]

−68.78 =

450

[−0.20]
[+0.11]
[+0.72]
[−0.42]
[+0.08]
[−0.47]
[+0.18]

440

[68.58]
[68.88]
[69.50]
[68.35]
[68.85]
[68.31]
[68.96]

410

[70.41, 69.96, 68.82, 69.15, ... 67.22, 68.16, 67.22, 67.06]
[70.62. 70.34. 69.13. 69.45. ... 67.28, 68.47, 67.59, 67.46]
...
[70.41, 69.96, 68.82, 69.15, ... 67.22, 68.16, 67.22, 67.06]
[70.62. 70.34. 69.13. 69.45. ... 67.28, 68.47, 67.59, 67.46]

420

[70.50, 70.00, 69.00, 69.30, ... 67.50, 68.40, 67.50, 67.30]

norm = 68.78

FIG.4

16

START

OBTAIN SOC VALUE OF EACH OF PLURALITY OF BATTERY CELLS ⎯S100

CALCULATE CHARGING/DISCHARGING SOC DIFFERENCE OF
EACH OF PLURALITY OF
BATTERY CELLS IN EVERY CHARGING/DISCHARGING CYCLE ⎯S200

CALCULATE SOC DIFFERENCE-TO-AVERAGE OF
EACH OF PLURALITY OF BATTERY CELLS BASED ON
CHARGING/DISCHARGING SOC DIFFERENCE ⎯S300

CALCULATE PLURALITY OF
INDICATORS ONE-TO-ONE CORRESPONDING TO
PLURALITY OF BATTERY CELLS,
BASED ON SOC DIFFERENCE-TO-AVERAGE ⎯S400

DIAGNOSE ABNORMALITY OF EACH OF PLURALITY OF
BATTERY CELLS BASED ON PLURALITY OF INDICATORS ⎯S500

END

FIG.5

```
┌─────────────────────────────────────────────────────┐
│        CALCULATE AVERAGE CHARGING/DISCHARGING        │
│         SOC DIFFERENCE OF EACH OF PLURALITY OF       │──S310
│    BATTERY CELLS IN EVERY CHARGING/DISCHARGING CYCLE │
└─────────────────────────────────────────────────────┘
                          │
┌─────────────────────────────────────────────────────┐
│         CALCULATE TOTAL CYCLE AVERAGE BASED ON       │
│    AVERAGE CHARGING/DISCHARGING SOC DIFFERENCES      │──S320
│      CALCULATED IN EVERY CHARGING/DISCHARGING CYCLE  │
└─────────────────────────────────────────────────────┘
                          │
┌─────────────────────────────────────────────────────┐
│    CALCULATE SOC DIFFERENCE-TO-AVERAGE BASED ON      │
│         CHARGING/DISCHARGING SOC DIFFERENCE,         │──S330
│    AVERAGE CHARGING/DISCHARGING SOC DIFFERENCE,      │
│            AND TOTAL CYCLE AVERAGE                    │
└─────────────────────────────────────────────────────┘
```

FIG.6

CALCULATE FIRST TARGET VALUE INDICATING AVERAGE OF
SOC DIFFERENCES-TO-AVERAGE OF
DIAGNOSIS TARGET BATTERY CELL AMONG PLURALITY OF
BATTERY CELLS IN ALL CYCLES — S410

CALCULATE SECOND TARGET VALUE INDICATING AVERAGE OF
ALL SOC DIFFERENCES-TO-AVERAGE OF
PLURALITY OF BATTERY CELLS IN ALL CYCLES — S420

CALCULATE INDICATOR OF
DIAGNOSIS TARGET BATTERY CELL BASED ON
FIRST TARGET VALUE AND SECOND TARGET VALUE — S430

FIG.7

1000

| MEMORY 1020 | | COMMUNICATION I/F 1040 |

| MCU 1010 | | INPUT/OUTPUT I/F 1030 |

FIG.8

## INTERNATIONAL SEARCH REPORT

| International application No. |
| --- |
| **PCT/KR2024/018216** |

| A. | CLASSIFICATION OF SUBJECT MATTER |
| --- | --- |

**G01R 31/382**(2019.01)i; **G01R 31/392**(2019.01)i; **G01R 31/367**(2019.01)i; **G01R 19/165**(2006.01)i; **G01R 31/56**(2020.01)i; **H02J 7/00**(2006.01)i

According to International Patent Classification (IPC) or to both national classification and IPC

| B. | FIELDS SEARCHED |
| --- | --- |

Minimum documentation searched (classification system followed by classification symbols)

G01R 31/382(2019.01); G01R 19/00(2006.01); G01R 31/36(2006.01); G01R 31/50(2020.01); H01M 10/48(2006.01); H01M 2/10(2006.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리 진단 장치(battery diagnosing apparatus), SOC 차이값(SOC difference value), 지표값(index value), 평균(average)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | KR 10-2022-0167847 A (LG ENERGY SOLUTION, LTD.) 22 December 2022 (2022-12-22) See paragraphs [0076]-[0077] and claims 1 and 3. | 1-2,6-7 |
| Y | | 3-5,8-10 |
| Y | KR 10-2020-0024637 A (SAMSUNG SDI CO., LTD.) 09 March 2020 (2020-03-09) See claim 4. | 3-5,8-10 |
| A | KR 10-2011-0087565 A (SB LIMOTIVE CO., LTD.) 03 August 2011 (2011-08-03) See paragraphs [0023]-[0067]. | 1-10 |
| A | JP 2011-196705 A (HITACHI LTD.) 06 October 2011 (2011-10-06) See paragraphs [0012]-[0107]. | 1-10 |
| A | JP 2019-211289 A (MAZDA MOTOR CORP.) 12 December 2019 (2019-12-12) See claims 1-5. | 1-10 |

| ☐ Further documents are listed in the continuation of Box C. | ☑ See patent family annex. |
| --- | --- |

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **25 February 2025** | **25 February 2025** |

| Name and mailing address of the ISA/KR | Authorized officer |
| --- | --- |
| **Korean Intellectual Property Office** **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2024/018216**

| Patent document cited in search report | | | Publication date (day/month/year) | Patent family member(s) | | | Publication date (day/month/year) |
|---|---|---|---|---|---|---|---|
| KR | 10-2022-0167847 | A | 22 December 2022 | CN | 116601508 | A | 15 August 2023 |
| | | | | EP | 4202464 | A1 | 28 June 2023 |
| | | | | JP | 2023-538052 | A | 06 September 2023 |
| | | | | JP | 7563862 | B2 | 08 October 2024 |
| | | | | US | 12203996 | B2 | 21 January 2025 |
| | | | | US | 2023-0333170 | A1 | 19 October 2023 |
| | | | | WO | 2022-265358 | A1 | 22 December 2022 |
| KR | 10-2020-0024637 | A | 09 March 2020 | KR | 10-2570266 | B1 | 24 August 2023 |
| | | | | US | 11513162 | B2 | 29 November 2022 |
| | | | | US | 2020-0072912 | A1 | 05 March 2020 |
| KR | 10-2011-0087565 | A | 03 August 2011 | CN | 102136743 | A | 27 July 2011 |
| | | | | CN | 102136743 | B | 29 July 2015 |
| | | | | EP | 2348599 | A1 | 27 July 2011 |
| | | | | JP | 2011-155825 | A | 11 August 2011 |
| | | | | JP | 5117537 | B2 | 16 January 2013 |
| | | | | KR | 10-1057542 | B1 | 17 August 2011 |
| | | | | US | 2011-0181246 | A1 | 28 July 2011 |
| | | | | US | 8264201 | B2 | 11 September 2012 |
| JP | 2011-196705 | A | 06 October 2011 | | None | | |
| JP | 2019-211289 | A | 12 December 2019 | JP | 7183577 | B2 | 06 December 2022 |

Form PCT/ISA/210 (patent family annex) (July 2022)

**EP 4 768 942 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240054761